# EUROPEAN PATENT APPLICATION

(11) **EP 2 444 997 A1**
(43) Date of publication of application: **25.04.2012**
(21) Application number: 10789344.8
(22) Date of filing: 24.05.2010
(51) Int. Cl.: H01L 21/31, C23C 16/458, H01L 21/683

(54) **PLASMA PROCESSING APPARATUS AND PLASMA PROCESSING METHOD**

(30) Priority: 18.06.2009 JP 2009145195
(71) Applicant: Mitsubishi Heavy Industries, Ltd., Tokyo 108-8215 (JP)
(72) Inventor: MATSUDA Ryuichi, Tokyo 108-8215 (JP); YOSHIDA Kazuto, Tokyo 108-8215 (JP)
(74) Representative: HOFFMANN EITLE
(86) International application number: PCT/JP2010/058732
(87) International publication number: WO 2010/146969

(57) **Abstract**

Provided are a plasma processing apparatus and a plasma processing method, wherein a substrate supporting table is supported such that nonuniformity of heat release is eliminated and maintenance is facilitated. In the plasma CVD apparatus (10), a supporting beam (12), which has inside thereof a through hole (12c) penetrating the facing side walls (11a) of a vacuum chamber (11) and traverses the vacuum chamber (11) by passing through the center of the vacuum chamber, is integrally formed with the vacuum chamber (11). In the center portion of the upper surface of the supporting beam (12), an upper surface opening (12a) for attaching a substrate supporting table (13) is provided, and a substrate supporting table (13) having a cylindrical shape is attached to the upper surface opening (12a) by having therebetween a first seal member that seals together the vacuum side and the atmosphere side.

## Description

### TECHNICAL FIELD

The present invention relates to a plasma processing apparatus having a substrate supporting table on which a substrate is placed and to a plasma processing method using the plasma processing apparatus.

### BACKGROUND ART

Supporting structures for a substrate supporting table on which a substrate is placed in the plasma processing apparatus are roughly divided into two types. One type of structure supports the substrate supporting table from a bottom surface of a vacuum chamber, and the other supports the substrate supporting table from a side surface of the vacuum chamber. These two types of structures are known as conventional arts (Patent Documents 1, 2).
Patent Document 1: Japanese Patent Application Publication No. Hei 9-167762
Patent Document 2: Japanese Patent Application Publication No. 2002-208584

### DISCLOSURE OF THE INVENTION

### PROBLEMS TO BE SOLVED BY THE INVENTION

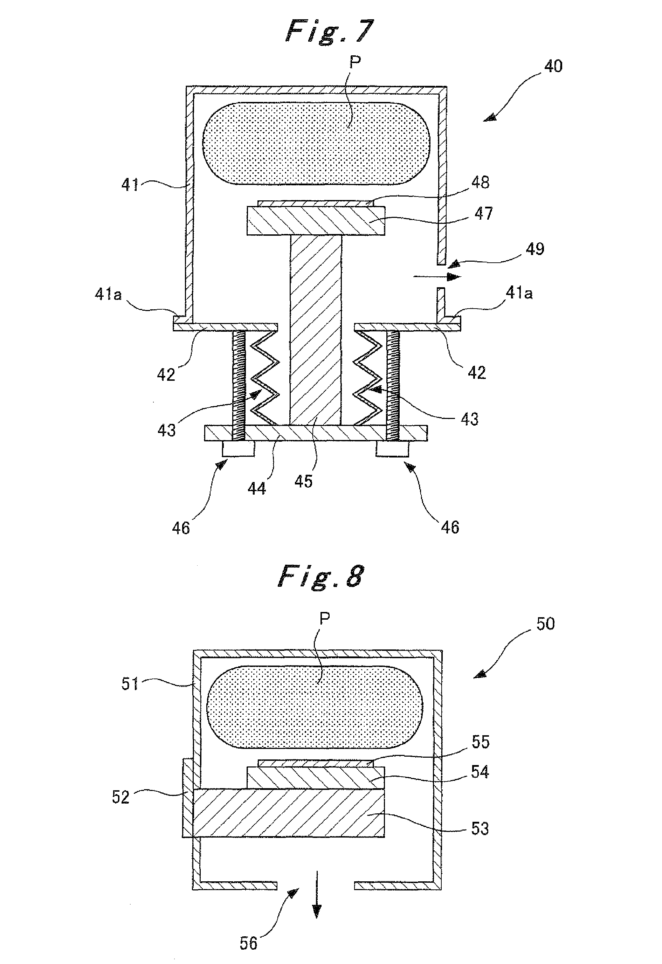

The following problems occur in the supporting structure supporting the substrate supporting table from the bottom surface of the vacuum chamber. These problems will be described with reference to Fig. 7. Note that, Fig. 7 is a cross-sectional view of a conventional plasma CVD apparatus having the supporting structure supporting the substrate supporting table from the bottom surface of the vacuum chamber. Note that, illustrations of a plasma generation mechanism, a gas supplying mechanism, a vacuum mechanism, and the like are omitted in Fig. 7.

A plasma CVD apparatus 40 shown in Fig. 7 includes: a vacuum chamber 41 in which a vacuum is created and plasma P is generated; a bottom surface 42 which is attached to a flange 41a of the vacuum chamber 41; a bellows 43 which is attached to a center portion of the bottom surface 42 and is expandable and contractable; a drive plate 44 which closes the bellows 43 and moves vertically by the drive of ball screws 46; a drive member 45 which is attached to an upper surface of the drive plate 44 and moves vertically together with the drive plate 44; and a placing table 47 which is attached to an upper surface of the drive member 45 and on which a substrate 48 is placed. In other words, the plasma CVD apparatus 40 has the supporting structure which supports the substrate supporting table (placing table 47, drive member 45) from the bottom surface 42 of the vacuum chamber 41, and also has the drive mechanism capable of vertically moving the substrate supporting table itself.

As shown in Fig. 7, the substrate supporting table is supported by the bottom surface 42, and the bottom surface 42 needs to be removed in maintenance. However, this removal is not easy. Moreover, in such a supporting structure, it is difficult to provide an evacuation port for vacuum in the bottom surface 42; thus, an evacuation port 49 for vacuum is provided in a side surface of the vacuum chamber 41 in many cases. In such case, the evacuation of the vacuum chamber 41 is performed unevenly. Thus, in a region with such degree of a vacuum that the pressure is relatively high, i.e. a region having a viscous flow close to a molecular flow, gas flows in a film formation process and a cleaning process are affected.

Moreover, the following problems occur in the supporting structure supporting the substrate supporting table from the side surface of the vacuum chamber. These problems will be described with reference to Fig. 8. Note that, Fig. 8 is a cross-sectional view of a conventional plasma CVD apparatus having the supporting structure supporting the substrate supporting table from the side surface of the vacuum chamber. Illustrations of a plasma generation mechanism, a gas supplying mechanism, a vacuum mechanism, and the like are also omitted in Fig. 8.

A plasma CVD apparatus 50 shown in Fig. 8 includes: a vacuum chamber 51 in which a vacuum is created and plasma P is generated; an arm member 53 which extends from a side wall of the vacuum chamber 51 toward a center portion and is supported by a plate 52; and a substrate supporting table 54 which is supported by an upper surface of the arm member 53 and on which a substrate 55 is placed.

As shown in Fig. 8, the substrate supporting table 54 is supported by the single arm member 53 on the side surface of the vacuum chamber 51. This is a so-called cantilever beam structure. In maintenance, the supporting table unit (arm member 53, substrate supporting table 54) is removed from the side surface of the vacuum chamber 51, and a new supporting table unit is then inserted. However, the supporting table unit is a single large replacement part, and is expensive and heavy. Thus, the replacement work is not easy. In such supporting structure, an evacuation port 56 for vacuum can be provided in a bottom surface of the vacuum chamber 51. However, since the supporting structure is the cantilever beam structure, the evacuation of the vacuum chamber 51 is performed unevenly as well. Thus, in a region with such degree of a vacuum that the pressure is relatively high, i.e. a region having a viscous flow close to a molecular flow, gas flows in a film formation process and a cleaning process are affected.

The present invention is made in view of the problems described above, and an object thereof is to provide a plasma processing apparatus and a plasma processing method in which a substrate supporting table is supported in such a way that uneven evacuation is prevented and maintenance is performed easily.

### MEANS FOR SOLVING THE PROBLEMS

A plasma processing apparatus according to a first invention for solving the above problems is a plasma processing apparatus in which a desired gas is supplied into a cylindrical vacuum chamber, a pressure inside the vacuum chamber is controlled by using a pressure control valve attached to a lower portion of the vacuum chamber and a vacuum pump attached to a lower portion of the pressure control valve, and desired plasma processing is performed on a substrate placed on a cylindrical substrate supporting table in the vacuum chamber, wherein
a supporting beam is formed integrally with the vacuum chamber, the supporting beam having therein a through-hole penetrating opposing sides of a side wall of the vacuum chamber, and traversing the vacuum chamber while passing through a center of the vacuum chamber,
an opening to which the substrate supporting table is attached is provided in a center portion of an upper surface of the supporting beam, and
the substrate supporting table is attached to the opening with a first sealing member in between, the first sealing member sealing a vacuum side and an atmosphere side from each other.

A plasma processing apparatus according to a second invention for solving the above problems is a plasma processing apparatus in which a desired gas is supplied into a cylindrical vacuum chamber, a pressure inside the vacuum chamber is controlled by using a pendulum gate valve attached to a lower portion of the vacuum chamber and a vacuum pump attached to a lower portion of the pendulum gate valve, and desired plasma processing is performed on a substrate placed on a cylindrical substrate supporting table in the vacuum chamber, wherein
a supporting beam is formed integrally with the vacuum chamber, the supporting beam having therein a through-hole penetrating opposing sides of a side wall of the vacuum chamber, and traversing the vacuum chamber while passing through a center of the vacuum chamber,
an opening to which the substrate supporting table is attached is provided in a center portion of an upper surface of the supporting beam,
the substrate supporting table is attached to the opening with a first sealing member in between, the first sealing member sealing a vacuum side and an atmosphere side from each other, and
the pendulum gate valve is attached to the vacuum chamber while being eccentric in a traversing direction of the supporting beam or in a direction orthogonal to the traversing direction, in such a way that an area center of an opening region at a defined opening ratio of the pendulum gate value coincides with an axial center of the vacuum chamber, the defined opening ratio is a center value of a recommended usage value of an opening ratio of the pendulum gate value.

A plasma processing apparatus according to a third invention for solving the above problems is the plasma processing apparatus according to the first or second invention, wherein the substrate supporting table includes:
a cylindrical inner tube which has a lower end portion thereof attached to a periphery of the opening of the supporting beam with the first sealing member in between;
a bellows which is disposed on an outer circumferential side of the inner tube, and which has an upper end portion thereof attached to an upper end portion of the inner tube by welding or with a second sealing member in between;
a cylindrical outer tube which is disposed on an outer circumferential side of the bellows, and which has a lower end portion thereof attached to a lower end portion of the bellows by welding or with a third sealing member in between;
a disc-shaped placing table which is attached to close an opening in an upper end portion of the outer tube with a fourth sealing member in between, and on which the substrate is placed;
a cylindrical covering member which is provided in tight contact with the outer tube while covering an entire surface of the outer tube, and which is made of a corrosion resistant material;
a drive member which is attached to a back surface of the placing table through an inside of the inner tube; and
a drive mechanism which is provided in the through-hole, and which changes a position of the substrate placed on the placing table by driving the drive member.

A plasma processing method according to a fourth invention for solving the above problems is a plasma processing method using the plasma processing apparatus according to any one of the first to third inventions, comprising:
supplying gas into the vacuum chamber;
controlling the pressure inside the vacuum chamber by using the pressure control valve and the vacuum pump;
generating plasma of the gas; and
performing the plasma processing on the substrate placed on the substrate supporting table.

### EFFECTS OF THE INVENTION

In the first invention, the cylindrical substrate supporting table is attached to the supporting beam traversing the vacuum chamber. Thus, in a portion around the substrate supporting table, the evacuation is performed uniformly and axial-symmetrically, where the axis is the substrate supporting table. In addition, in a portion around the supporting beam, the evacuation is performed uniformly and plane-symmetrically, where the plane is the supporting beam. Moreover, since the substrate supporting table is attached to the opening of the supporting beam integral with the vacuum chamber, the substrate supporting table is positioned easily. In addition, the removal, assembly, replacement, and the like of the substrate supporting table can be easily performed in maintenance. As a result, uneven evacuation is suppressed, and the maintainability is improved as well.

In the second invention, the cylindrical substrate supporting table is attached to the supporting beam traversing the vacuum chamber, and the pendulum gate valve is attached to the vacuum chamber while being eccentric in the traversing direction of the supporting beam or in the direction orthogonal to the traversing direction, in such a way that the area center of the opening region at the defined opening ratio of the pendulum gate valve coincides with the axial center of the vacuum chamber. The defined opening ratio is the center value of the recommended usage value of an opening ratio of the pendulum gate valve. Thus, in the portion around the substrate supporting table, the evacuation is performed uniformly and axial-symmetrically, where the axis is the substrate supporting table. In addition, in the portion around the supporting beam, the evacuation is performed uniformly and plane-symmetrically, where the plane is the supporting beam. Moreover, since the substrate supporting table is attached to the opening of the supporting beam integral with the vacuum chamber, the substrate supporting table is positioned easily. In addition, the removal, assembly, replacement, and the like of the substrate supporting table can be easily performed in maintenance. As a result, uneven evacuation is further suppressed, and the maintainability is improved as well.

In the third invention, even if the substrate supporting table includes the drive mechanism capable of changing the position of the substrate, the drive mechanism can be disposed in the through-hole inside the supporting beam. Thus, the evacuation of the vacuum chamber is not affected and can be performed uniformly.

In the fourth invention, uneven evacuation is suppressed when plasma processing is performed using the plasma processing apparatus according to any one of the first to third inventions. Thus, an in-plane uniformity of the plasma processing performed on the substrate placed on the substrate supporting table can be improved.

### BRIEF DESCRIPTION OF THE DRAWINGS

[Fig. 1] Fig. 1 shows an example of an embodiment of a plasma processing apparatus of the present invention, and Parts (a) and (b) are cross-sectional views of a plasma CVD apparatus taken at positions different from each other by 90°.
[Fig. 2] Part (a) is a perspective view of a lower chamber of the plasma CVD apparatus shown in Fig. 1, and Part (b) is a perspective view of the lower chamber, an upper chamber, and a substrate supporting table portion of the plasma CVD apparatus shown in Fig. 1.
[Fig. 3] Fig. 3 is a cross sectional view showing an example of the substrate supporting table which is vertically moveable.
[Fig. 4] Fig. 4 is a cross-sectional view showing an example of an evacuation structure attached to a lower portion of the plasma CVD apparatus shown in Fig. 1.
[Fig. 5] Fig. 5 is a cross-sectional view taken along the line A-A and viewed in the direction of the arrows A of Fig. 4.
[Fig. 6] Fig. 6 is a perspective view showing a modified example of a connection member shown in Fig. 4.
[Fig. 7] Fig. 7 is a cross-sectional view of a conventional plasma CVD apparatus having a supporting structure supporting a substrate supporting table from a bottom surface of a vacuum chamber.
[Fig. 8] Fig. 8 is a cross-sectional view of a conventional plasma CVD apparatus having a supporting structure supporting the substrate supporting table from a side surface of the vacuum chamber.

### EXPLANATION OF THE REFERENCE NUMERALS

- 10: PLASMA CVD APPARATUS
- 11: LOWER CHAMBER
- 12: SUPPORTING BEAM
- 12a: UPPER SURFACE OPENING
- 12c: THROUGH-HOLE
- 13, 20: SUBSTRATE SUPPORTING TABLE
- 13a: SUPPORTING TUBE
- 13b: PLACING TABLE
- 15: SUBSTRATE
- 16: UPPER CHAMBER
- 17: CEILING PLATE
- 31, 31': CONNECTION MEMBER
- 32: PENDULUM GATE VALVE
- 34: TMP

### BEST MODES FOR CARRYING OUT THE INVENTION

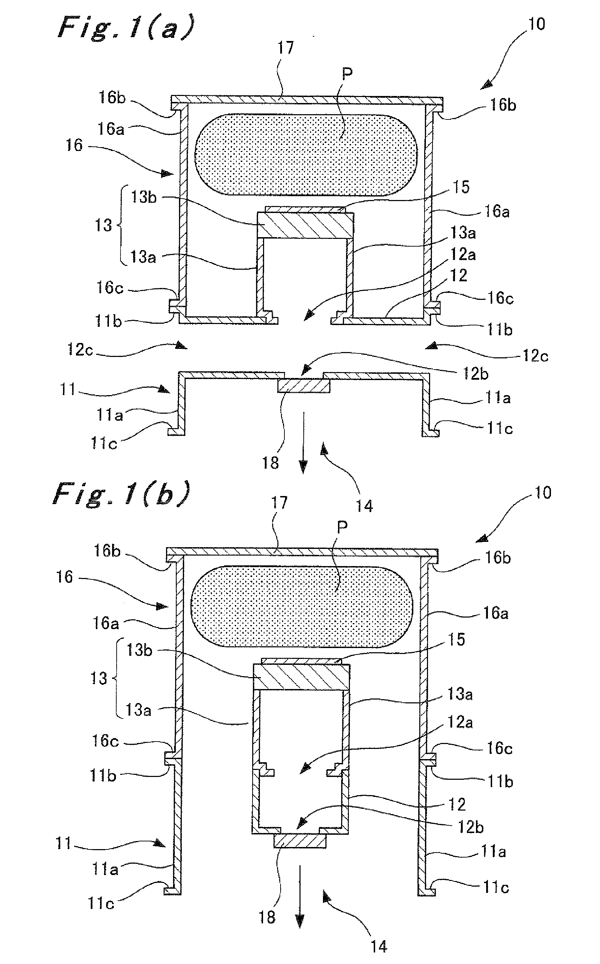

Embodiments of a plasma processing apparatus and a plasma processing method of the present invention will be described with reference to Figs. 1 to 6. Note that, a plasma CVD apparatus is given as an example in this description. However, the present invention is applicable not only to the plasma CVD apparatus but also to a plasma etching apparatus.

### (Embodiment 1)

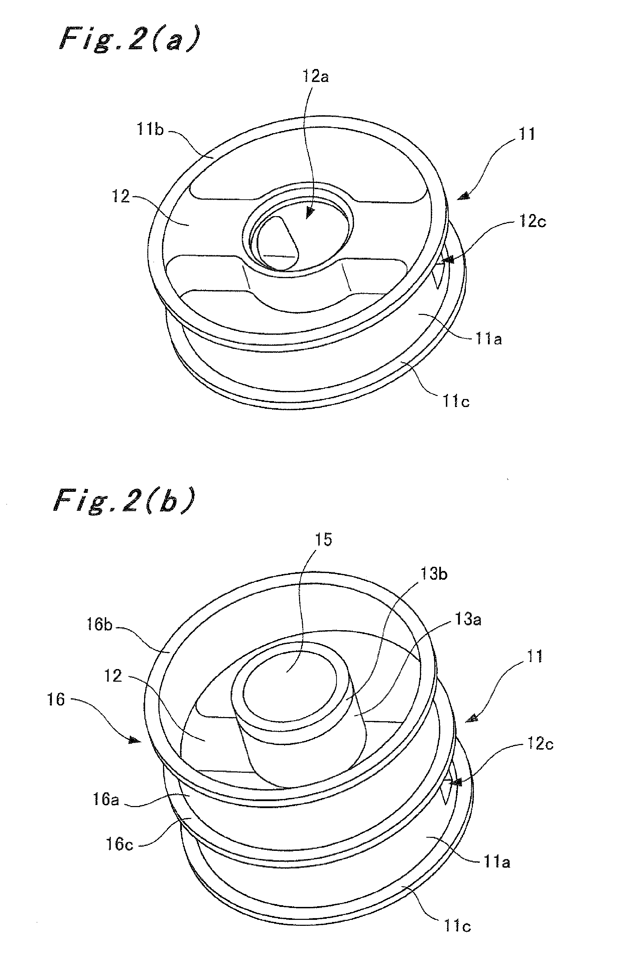

A plasma CVD apparatus of an embodiment will be described with reference to Figs. 1 and 2. Here, Part (a) of Fig. 1 is a cross-sectional view of the plasma CVD apparatus of the embodiment, and Part (b) of Fig. 1 is a cross-sectional view of the plasma CVD apparatus taken at a position orthogonal to Fig. 1 (a) . Moreover, Part (a) of Fig. 2 is a perspective view of a lower chamber of the plasma CVD apparatus shown in Fig. 1, and Part (b) of Fig. 2 is a perspective view of the lower chamber, an upper chamber, and a substrate supporting table portion of the plasma CVD apparatus shown in Fig. 1. Note that, in Figs. 1 and 2, illustrations of a gas supplying mechanism supplying desired gas to a vacuum chamber, a plasma generation mechanism generating plasma in the vacuum chamber, a vacuum mechanism controlling the pressure inside the vacuum chamber, and the like are omitted.

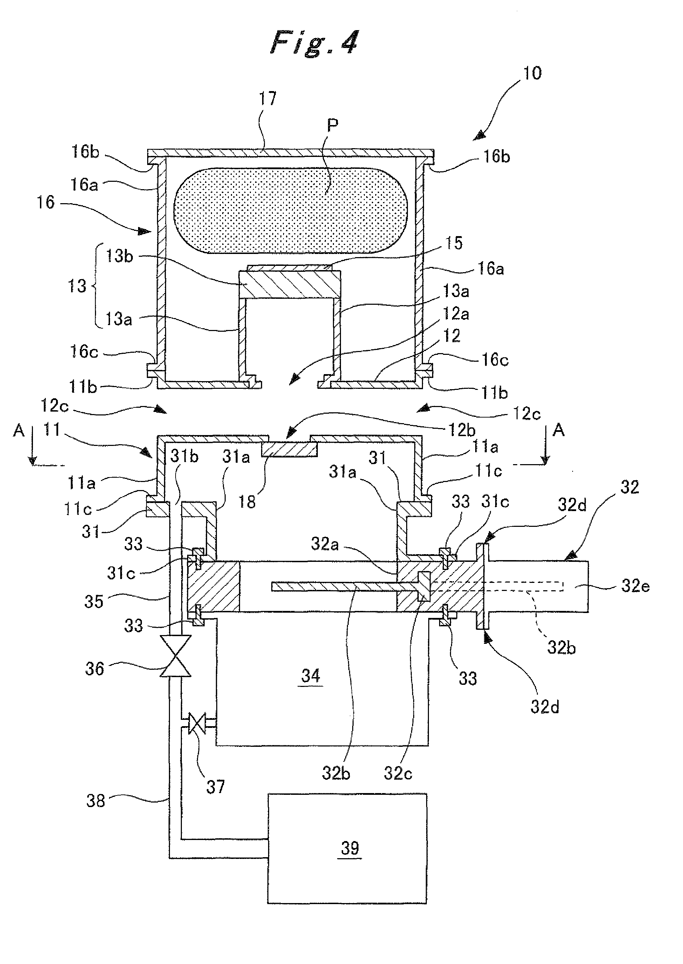

In the embodiment, a plasma processing apparatus 10 includes a lower chamber 11, an upper chamber 16, and a ceiling plate 17 which constitute a cylindrical vacuum chamber. The lower chamber 11 and the upper chamber 16 are attached to each other at their respective flanges 11b, 16c, and are sealed by an unillustrated sealing member such as an O-ring to create a vacuum inside the chambers. Furthermore, the ceiling plate 17 is attached to a flange 16b in an upper opening of the upper chamber 16, and is sealed by an unillustrated sealing member such as an O-ring to create a vacuum inside the chambers. Note that, a flange 11c in a lower portion of the lower chamber 11 is an ordinary circular flange. A pressure control valve and a vacuum pump (a pendulum gate valve and a turbomolecular pump as shown in Fig. 4 described later, for example) for controlling the pressure inside the vacuum chamber are sequentially attached to the flange 11c, although illustrations thereof are omitted in the drawings.

The vacuum chamber is provided therein with a substrate supporting table 13 formed of a disc-shaped placing table 13b on which a substrate 15 is placed and a cylindrical supporting tube 13a which supports the placing table 13b. The substrate 15 placed on the substrate supporting table 13 is subjected desired plasma processing. Note that, a space between the placing table 13b and the supporting tube 13a are sealed by an unillustrated sealing member such as an O-ring.

A supporting beam 12 traversing the lower chamber 11 in a diametrical direction while passing through the center of the lower chamber 11 is provided in the lower chamber 11 as a supporting structure supporting the substrate supporting table 13. The supporting beam 12 has a rectangular cross section with a flat upper surface. The supporting beam 12 is provided from one side of a cylindrical side wall 11a to the other side of the cylindrical side wall 11a opposing to the one side with the center of the lower chamber 11 in between. Moreover, a through-hole 12c having a rectangular cross section is provided in the supporting beam 12. In other words, the through-hole 12c of the supporting beam 12 is formed to pass through the center of the lower chamber 11 and to penetrate the cylindrical side wall 11a in the diametrical direction across the opposing sides. The supporting beam 12 is formed integrally with the lower chamber 11. Note that, the lower chamber 11 and the upper chamber 16 may be formed integrally.

A circular upper surface opening 12a is provided in a center portion of an upper surface of the supporting beam 12 so as to install the substrate supporting table 13. The supporting tube 13a of the substrate supporting table 13 is attached to the upper surface opening 12a with an unillustrated sealing member (first sealing member) such as an O-ring in between, so that the vacuum side and the atmosphere side are sealed from each other. Moreover, a lower surface opening 12b is provided in a center portion of a lower surface of the supporting beam 12 which faces the upper surface opening 12a, so as to make the through-hole 12c accessible in maintenance. A closing plate 18 is attached to the lower surface opening 12b with an unillustrated sealing member such as an O-ring in between. Note that, since the upper surface and lower surface of the supporting beam 12 are flat, the circular upper surface opening 12a and the lower surface opening 12b can be easily formed.

Accordingly, the inside of the substrate supporting table 13 communicates with the outside of the vacuum chamber through the through-hole 12c of the supporting beam 12, and is in an atmospheric state together with the through-hole 12c. Meanwhile, the outside of the substrate supporting table 13 is closed by the vacuum chamber formed of the lower chamber 11, upper chamber 16, and ceiling plate 17 described above, and can be set to a vacuum state by use of a vacuum pump.

As described above, the supporting structure of the supporting beam 12 is a so-called both-end-support beam, and the substrate supporting table 13 is installed on the supporting beam 12 being a both-end-support beam.

The placing table 13b is generally provided with an electrode for electrostatic attraction, an electrode for applying a bias, a heater for heating, a sensor for detecting a temperature, a flow passage for cooling, and the like. Since the inside of the substrate supporting table 13 and the through-hole 12c of the supporting beam 12 are in the atmospheric state because of the supporting structure described above, the devices and the like listed above are connected in the atmospheric side. In this case, unlike in the vacuum state, an electrical discharge does not occur in an electrode portion to which a high voltage is applied. Moreover, even if a coolant leaks from the flow passage for cooling or the like, the coolant leaks in the atmospheric side. Thus, the inside of the vacuum chamber is not affected. Furthermore, as shown in Embodiment 2 described below, in a case of incorporating a drive mechanism for vertically moving the substrate supporting table, the drive mechanism can be provided in the substrate supporting table 13 and the through-hole 12c of the supporting beam 12. Thus, the vacuum mechanism (pressure control valve, vacuum pump, and the like) can be disposed directly below the vacuum chamber.

Moreover, the supporting beam 12 is formed integrally with the lower chamber 11. Thus, portions to be removed in maintenance are only the placing table 13b and the supporting tube 13a which are light. Hence, the maintenance can be performed very easily. In the maintenance, for example, the ceiling plate 17 is removed first and then the placing table 13b and the supporting tube 13a are removed sequentially. When a replacement is required, only the placing table 13b and the supporting tube 13a above the supporting beam 12 need to be replaced. Furthermore, the upper surface opening 12a being the install position of the supporting tube 13a is formed in the supporting beam 12 in advance. Thus, the substrate supporting table 13 can be centered just by installing, and therefore the positioning thereof can be performed very easily. Since the supporting beam 12 being the supporting structure is simple as described above, the maintenance such as removal, assembly, replacement, and the like of the substrate supporting table 13 can be performed easily.

In addition, the substrate supporting table 13 is cylindrical. Thus, in a portion around the substrate supporting table 13, when the vacuum chamber is evacuated, the evacuation is performed uniformly and axial-symmetrically, where the substrate supporting table 13 is the axis. Moreover, in a portion around the supporting beam 12, the evacuation is performed uniformly and plane-symmetrically, where the supporting beam 12 is the plane. As a result, an in-plane uniformity of plasma processing (a thin film or the like formed by plasma CVD, for example) performed on the substrate 15 placed on the substrate supporting table 13 can be improved.

### (Embodiment 2)

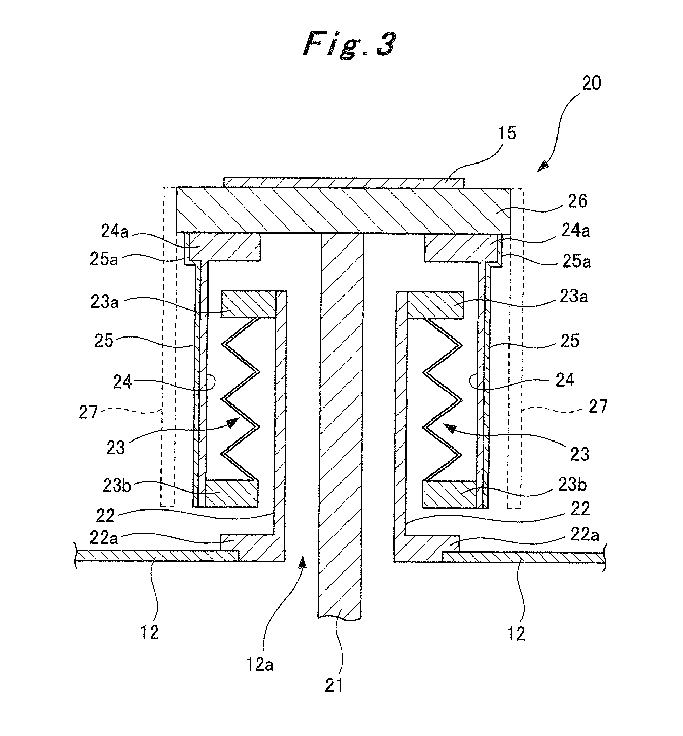

This embodiment is based on the structure of Embodiment 1, and uses a substrate supporting table capable of vertically moving the position of a substrate. Fig. 3 shows a cross-sectional view of the substrate supporting table having a vertically moveable structure. The embodiment will be described with reference to Fig. 3.

In the embodiment, a substrate supporting table 20 includes a cylindrical inner tube 22, a bellows 23, a cylindrical outer tube 24, and a placing table 26. The inner tube 22 has a lower flange 22a being a lower end portion thereof attached to a periphery of an upper surface opening 12a of a supporting beam 12. The bellows 23 is disposed on the outer circumferential side of the inner tube 22, and has an upper flange 23a being an upper end portion thereof attached to an outer circumferential surface of an upper end portion of the inner tube 22. The outer tube 24 is disposed on the outer circumferential side of the bellows 23, and has a lower end portion thereof attached to a lower flange 23b being a lower end portion of the bellows 23. The placing table 26 is attached to an upper flange 24a in such a way as to close an opening in an upper end portion of the outer tube 24. Moreover, a cover member 25 (covering member) is provided on an outer circumference of the outer tube 24, the cover member 25 being in tight contact with an outer circumferential surface of the outer tube 24 to cover the entire surface of the outer tube 24. In other words, a structure is provided in which, in a region directly below the placing table 26, the inner tube 22 is disposed on the innermost side, and the cylindrical inner tube 22, the bellows 23, the outer tube 24, and the cover member 25 being mutually different in diameter are disposed concentrically in this order from the inner side.

Moreover, the supporting beam 12 and the lower flange 22a are attached to each other with a sealing member (first sealing member) such as an O-ring in between. Similarly, the inner tube 22 and the upper flange 23a are attached to each other with a sealing member (second sealing member) such as an O-ring in between; the lower flange 23b and the outer tube 24 are attached to each other with a sealing member (third sealing member) such as an O-ring in between; and the upper flange 24a and the placing table 26 are attached to each other with a sealing member (fourth sealing member) such as an O-ring in between. In other words, the supporting beam 12, the inner tube 22, the bellows 23, the outer tube 24, and the placing table 26 are attached to one another with a sealing member in between. This configuration allows the placing table 26 to be vertically moveable by use of a drive mechanism (illustration omitted) while maintaining a vacuum inside the vacuum chamber. Note that, for the inner tube 22, the bellows 23, and the outer tube 24, at least one of a pair of the inner tube 22 and the bellows 23 and a pair of the bellows 23 and the outer tube 24 may be bonded and integrated together by welding in a way that there is no leakage, so as to maintain a vacuum.

Among the inner tube 22, the bellows 23, and the outer tube 24, at least the outer tube 24 is desirably made of a metal or an alloy having a relatively high melting point such for example as stainless steel to maintain the structure supporting the placing table 26 under a high temperature. Moreover, the cover member 25 is made of a corrosion resistant material such for example as aluminum whose surface is anodized or a ceramics such as high-purity alumina to avoid high-temperature corrosion of the outer tube 24 by a corrosive gas. It is particularly desirable that a portion of the upper flange 24a in direct contact with the placing table 26 be in tight contact with the cover member 25 without a gap, since the placing table 26 is sometimes set to a high temperature of about 400°C. For example, if the upper flange 24a protrudes to an outer circumferential side thereof as shown in Fig. 3, an upper end portion 25a of the cover member 25 is formed in conformity with the shape of the upper flange 24a, and put in tight contact without a gap. As a result, the outer tube 24 is exposed to the corrosive gas as little as possible.

Note that, a cylindrical skirt member (exterior member) 28 may be provided on the outer circumferential side of the cover member 25 to cover the entire surface of the cover member 25. The skirt member 28 is made of a corrosion resistant material as similar to the cover member 25, and is made of, for example, aluminum whose surface is anodized or a ceramics such as a high-purity alumina. Provision of the skirt member 28 allows a gas flowing on the outer circumferential side of the skirt member 28 to be regulated and evacuated uniformly, and also prevents the gas from moving toward the outer tube 24, the bellows 23, and the inner tube 22. As a result, corrosion of the outer tube 24, bellows 23, and inner tube 22 is prevented. Thus, metallic contamination due to the corrosion is prevented, and the product lives of these parts are extended.

Moreover, a drive member 21 is attached to a back surface of the placing table 16 through an opening 12a and the inside of the inner tube 22. The position of the substrate 15 can be changed by vertically moving the drive member 21 by use of the unillustrated drive mechanism to vertically move the placing table 26 and the substrate 15. The drive mechanism can be installed inside the substrate supporting table 20 or inside a through-hole 12c of the supporting beam 12, and thus does not prevent a vacuum mechanism (pressure control valve, vacuum device, and the like) from being disposed directly below the vacuum chamber. The substrate supporting table 20 including the drive mechanism is cylindrical as in Embodiment 1. Thus, in a portion around the substrate supporting table 20, when the vacuum chamber is evacuated, the evacuation is performed uniformly and axial-symmetrically, where the substrate supporting table 20 is the axis. Moreover, in a portion around the supporting beam 12, the evacuation is performed uniformly and plane-symmetrically, where the supporting beam 12 is the plane. As a result, an in-plane uniformity of plasma processing (a thin film or the like formed by plasma CVD, for example) performed on the substrate 15 placed on the substrate supporting table 20 can be improved.

In addition, in the substrate supporting table 20, the outer tube 24 is protected by the cover member 25. Therefore, even when the placing table 26 is heated to about 400°C, a high temperature portion is less likely to be exposed to the corrosive gas. Thus, and the high-temperature corrosion is suppressed. Moreover, a path from the placing table 26 to the bellows 23 and a path from the placing table 26 to the inner tube 22 are long, so that heat is less likely to be transmitted. Thus, the inner tube 22 and the bellows 23 are not heated to a high temperature, and even if they are exposed to the corrosive gas, the high temperature corrosion is suppressed. Accordingly, in the inner tube 22, the bellows 23, and the outer tube 24 which are metal members, the high temperature corrosion of these members is suppressed, so that the product lives of these members are extended, and also the metal contamination caused by these members is suppressed.

Moreover, in the substrate supporting table 20, the bellows 23 is expanded when the substrate 15 is transported, and is contracted when the substrate 15 is subjected to plasma processing. Thus, products and by-products adhering to a surface of the bellows 23 are reduced. Particularly, in a plasma CVD apparatus, since the formation of a film on the surface of the bellows 23 is reduced, generation of particles which is caused by the peeling of the formed thin film is reduced.

Furthermore, in the substrate supporting table 20, the upper flange 23a of the bellows 23 divides the entirety into two sides: the placing table 26 side that is moved vertically; and the inner tube 22 side that is fixed. Thus, it is possible to reduce the volume and weight of driven portions inside the vacuum chamber, and thus to reduce a load on the drive mechanism. Moreover, a pressure by atmospheric pressure may possibly be applied to the back surface of the placing table 26 due to failure of the drive mechanism or the like, in which case the bellows 23 moves in the direction to contract. This is safer than a case where the bellows 23 moves in the direction to expand, and prevents the bellows 23 from breaking.

### (Embodiment 3)

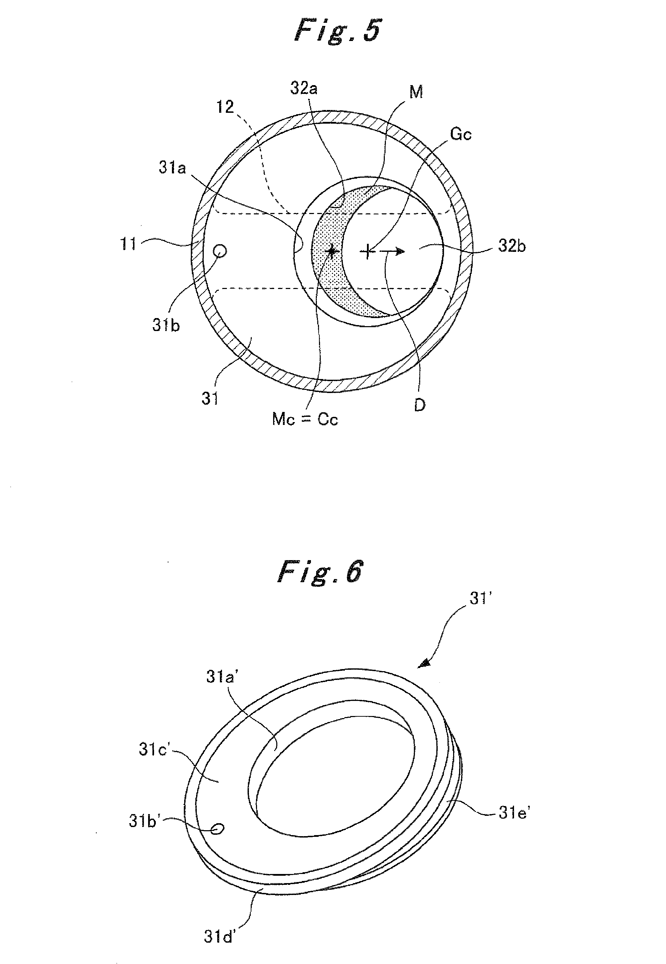

This embodiment is based on the structure of Embodiment 1, and is characterized in the position of a pendulum gate valve provided in a lower portion of a vacuum chamber. Fig. 4 shows a cross-sectional view of a plasma processing apparatus including the pendulum gate valve, and Fig. 5 shows a cross-sectional view taken along the line A-A and viewed in the direction the arrows A of Fig. 4. The embodiment will be described with reference to Figs. 4 and 5. Note that, illustrations of a plasma generating mechanism, a gas supplying mechanism, and the like are omitted in Fig. 4.

As shown in Fig. 4, the embodiment includes a pendulum gate valve 32 and a TMP (turbomolecular pump) 34 as an evacuation structure of the plasma processing apparatus 10 shown in Embodiment 1 (see Fig. 1 and the like) . The pendulum gate valve 32 is attached to a lower portion of a lower chamber 11 with a connection member 31 in between, and controls the pressure inside the vacuum chamber. The TMP 34 is attached to a lower portion of the pendulum gate valve 32, and evacuates the atmosphere inside the vacuum chamber. Note that, the connection member 31 is attached to a flange 11c of the lower chamber 11; the pendulum gate valve 32 is attached to a flange 31c of the connection member 31 with bolts 33 inserted from above; and the TMP 34 is attached to the pendulum gate valve 33 at a flange of the TMP 34 itself with bolts 33 inserted from below.

In the embodiment, the pendulum gate valve 32 is eccentrically attached to the lower chamber 11. Specifically, as shown in Fig. 5, the pendulum gate valve 32 is eccentrically disposed in such a way that an axis center Cc of the cylindrical lower chamber 11 coincides with an area center Mc of an opening region M of the pendulum gate valve 32. The opening region M changes in accordance with an opening ratio of the pendulum gate valve 32 as a matter of course. In the embodiment, the area center Mc of the opening region M is obtained on the basis of an opening region M at an opening ratio of 30% (a defined opening ratio), which is a center value of a recommended usage value range (10% to 50%) of the opening ratio of the pendulum gate valve 32. Then, the pendulum gate valve 32 is eccentrically disposed in such a way that the axis center Cc and the area center Mc coincide with each other. Accordingly, a center Gc in a state where an opening 32a of the pendulum gate valve 32 is fully opened is eccentric to the axis center Cc of the lower chamber 11 in an opening direction D of a valve body 32b opening and closing the opening 32a. Note that, the axis center of the upper chamber 16 coincides with the axis center Cc of the lower chamber 11. Moreover, a connection-portion center of the TMP 34 is disposed to coincide with the center Gc of the opening 32a of the pendulum gate valve 32.

The disposed position of the pendulum gate valve 32 is eccentric to a supporting beam 12 located thereabove in a traversing direction of the supporting beam 12. If the supporting beam 12 is considered as a single plane, the opening region M of the pendulum gate valve 32 is located plane-symmetrically with respect to the supporting beam 12. Specifically, a center line of the supporting beam 12 which passes through the axis center Cc = the area center Mc and which extends in the traversing direction line-symmetrically bisects the shape of the opening region M, and bisects the area of the opening region M.

If the parts are disposed to have the positional relationships described above, the evacuation is performed as follows when the opening ratio of the pendulum gate valve 32 is controlled to be around 30% and the inside of the vacuum chamber is controlled to a desired pressure. In a portion around the substrate supporting table 13, since the substrate supporting table 13 is cylindrical, the evacuation is performed uniformly and axial-symmetrically, where the substrate supporting table 13 is the axis. In a portion around the supporting beam 12, the evacuation is performed uniformly and plane-symmetrically, where the supporting beam 12 is the plane. When the opening ratio is not around 30% and the inside of the vacuum chamber is controlled to a desire pressure, the evacuation is slightly less uniform than when the opening ratio is 30%. Nonetheless, even in such case, the evacuation can be made more uniform than when the opening center of the pendulum gate valve coincides with the axis center of the vacuum chamber. As a result, an in-plane uniformity of plasma processing (a thin film or the like formed by plasma CVD, for example) performed on the substrate 15 placed on the substrate supporting table 13 can be further improved.

These effects are seen remarkably in processing performed in a relatively higher pressure in vacuum. For example, plasma cleaning in a plasma CVD apparatus is performed in a relatively higher pressure in vacuum. Conventionally, plasma cleaning has been performed unevenly, and there have been a case where excessive gas is consumed to perform certain cleaning and a case where excessive cleaning is performed on some portion thereby causing plasma damage. On the contrary, in the embodiment, uniform plasma cleaning is performed on the lower chamber 11, the upper chamber 16, and the substrate supporting table 13 by using the evacuation structure described above. As a result, damage due to excessive use of gas and plasma is reduced. Hence, it is possible to reduce the frequency of maintenance and extend the lives of the parts.

Note that, the pendulum gate valve 32 may be eccentric in a direction orthogonal to the traversing direction of the supporting beam 12. In such case, the center line mentioned above does not line-symmetrically bisect the shape of the opening region M but still bisects the area of the opening region M, thus making it possible to obtain effects close to those obtained when the pendulum gate valve 32 is eccentric in the traversing direction of the supporting beam 12.

Moreover, since the pendulum gate valve 32 is eccentrically attached, the opening 31a of the connection member 31 is also eccentrically provided, and the direction of this eccentricity also coincides with the opening direction D of the valve body 32b. As a result, a space is made in a portion opposite to the side in which the pendulum gate valve 32 and the connection member 31 are eccentrically disposed. This allows a port 31b for a roughing evacuation pipe 35 to be provided in the lower portion of the lower chamber 11 near a lateral side of the pendulum gate valve 32, and allows the roughing evacuation pipe 35, a valve 36, and the like to be disposed directly below the lower chamber 11 even if a port is in a side wall of the lower chamber 11. In the embodiment, to perform roughing of the inside of the vacuum chamber, the roughing evacuation pipe 35 is connected to the port 31b in a bottom portion of the vacuum chamber, and is connected to a roughing vacuum pump 39 through a valve 36 and an evacuation pipe 38. In addition, the evacuation pipe 38 is connected to an evacuation port of the TMP 34 through a valve 37. As described above, the roughing evacuation pipe 35, the valve 36, and the like can be disposed directly below the lower chamber 11, and be disposed efficiently together with the TMP 34 and the like in an internal space of the processing apparatus.

Furthermore, since the pendulum gate valve 32 is eccentrically connected, a standby portion 32e can be disposed outside of the side wall of the vacuum chamber. Accordingly, the position of a flange 32d is located more outward, and the standby portion 32e can be easily accessed. Accordingly, the maintenance of the valve body 32b can be performed by rotating the valve body 32b about a rotation shaft 32c to move the valve body 32b to the position of the standby portion 32e. Thus, the maintainability of the pendulum gate valve 32 can be also improved.

The eccentric connection of the pendulum gate valve 32 causes the bolts 33 on the side opposite to the standby portion 32e to be disposed on a closer side. Thus, difficulty in fastening and removing the bolts 33 can be also reduced.

Note that, in Figs. 4 and 5, the connection member 31 has a simple structure in which the opening 31a is eccentrically provided in a circular-plate-shaped member. However, a configuration like a connection member 31' shown in Fig. 6 can be employed to perform evacuation more smoothly. Specifically, the connection member 31' includes an eccentric opening 31a' and a roughing evacuation pipe port 31b', as similar to the connection member 31. However, an inclined portion 31c' is formed from an opening part in an upper portion of the connection member 31' to the opening 31a', and has such a structure that air is smoothly evacuated to the opening 31a' . Note that, in the connection member 31b', an upper flange 31d' is connected to a flange 11c of the lower chamber 11, and a lower flange 31e' is connected to the pendulum gate valve 32. Furthermore, the embodiment may be combined with the substrate supporting table 20 described in Embodiment 2.

### INDUSTRIAL APPLICABILITY

The present invention is preferably applied to a plasma processing apparatus and a plasma processing method for performing plasma processing such as plasma CVD and plasma etching used to manufacture a semiconductor device.

## Claims

1. A plasma processing apparatus in which a desired gas is supplied into a cylindrical vacuum chamber, a pressure inside the vacuum chamber is controlled by using a pressure control valve attached to a lower portion of the vacuum chamber and a vacuum pump attached to a lower portion of the pressure control valve, and desired plasma processing is performed on a substrate placed on a cylindrical substrate supporting table in the vacuum chamber, wherein
a supporting beam is formed integrally with the vacuum chamber, the supporting beam having therein a through-hole penetrating opposing sides of a side wall of the vacuum chamber, and traversing the vacuum chamber while passing through a center of the vacuum chamber,
an opening to which the substrate supporting table is attached is provided in a center portion of an upper surface of the supporting beam, and
the substrate supporting table is attached to the opening with a first sealing member in between, the first sealing member sealing a vacuum side and an atmosphere side from each other.

2. A plasma processing apparatus in which a desired gas is supplied into a cylindrical vacuum chamber, a pressure inside the vacuum chamber is controlled by using a pendulum gate valve attached to a lower portion of the vacuum chamber and a vacuum pump attached to a lower portion of the pendulum gate valve, and desired plasma processing is performed on a substrate placed on a cylindrical substrate supporting table in the vacuum chamber, wherein
a supporting beam is formed integrally with the vacuum chamber, the supporting beam having therein a through-hole penetrating opposing sides of a side wall of the vacuum chamber, and traversing the vacuum chamber while passing through a center of the vacuum chamber,
an opening to which the substrate supporting table is attached is provided in a center portion of an upper surface of the supporting beam,
the substrate supporting table is attached to the opening with a first sealing member in between, the first sealing member sealing a vacuum side and an atmosphere side from each other, and
the pendulum gate valve is attached to the vacuum chamber while being eccentric in a traversing direction of the supporting beam or in a direction orthogonal to the traversing direction, in such a way that an area center of an opening region at a defined opening ratio of the pendulum gate value coincides with an axial center of the vacuum chamber, the defined opening ratio is a center value of a recommended usage value of an opening ratio of the pendulum gate value.

3. The plasma processing apparatus according to claim 1 or 2, wherein the substrate supporting table includes:
a cylindrical inner tube which has a lower end portion thereof attached to a periphery of the opening of the supporting beam with the first sealing member in between;
a bellows which is disposed on an outer circumferential side of the inner tube, and which has an upper end portion thereof attached to an upper end portion of the inner tube by welding or with a second sealing member in between;
a cylindrical outer tube which is disposed on an outer circumferential side of the bellows, and which has a lower end portion thereof attached to a lower end portion of the bellows by welding or with a third sealing member in between;
a disc-shaped placing table which is attached to close an opening in an upper end portion of the outer tube with a fourth sealing member in between, and on which the substrate is placed;
a cylindrical covering member which is provided in tight contact with the outer tube while covering an entire surface of the outer tube, and which is made of a corrosion resistant material;
a drive member which is attached to a back surface of the placing table through an inside of the inner tube; and
a drive mechanism which is provided in the through-hole, and which changes a position of the substrate placed on the placing table by driving the drive member.

4. A plasma processing method using the plasma processing apparatus according to any one of claims 1 to 3, comprising:
supplying gas into the vacuum chamber;
controlling the pressure inside the vacuum chamber by using the pressure control valve and the vacuum pump;
generating plasma of the gas; and
performing the plasma processing on the substrate placed on the substrate supporting table.
